# EUROPEAN PATENT APPLICATION

(11) **EP 4 814 365 A1**
(43) Date of publication of application: **30.09.2026**
(21) Application number: 24893609.8
(22) Date of filing: 22.11.2024
(51) Int. Cl.: F21K 9/64, F21V 19/00, H05B 45/30, F21Y 115/10, F21Y 113/13

(54) **LIGHT SOURCE MODULE, LIGHTING SYSTEM AND LAMP**

(30) Priority: 23.11.2023 CN 202311582047; 23.11.2023 CN 202323178453 U
(71) Applicant: Suzhou Opple Lighting Co., Ltd., Suzhou, Jiangsu 215211 (CN); Opple Lighting Co., Ltd., Shanghai 201203 (CN)
(72) Inventor: ZHU, Changrong, Suzhou, Jiangsu 215211 (CN)
(74) Representative: Winter, Brandl - Partnerschaft mbB
(86) International application number: PCT/CN2024/133931
(87) International publication number: WO 2025/108456

(57) **Abstract**

A light source module, a lighting system and a lamp. The light source module comprises a first light-emitting unit (100), a second light-emitting unit (200) and a third light-emitting unit (300) which are electrically independent of each other, light emitted from the light-emitting units being mixed to form white light. By means of the selection of the light colors and spectral characteristics of the light-emitting units, the white light obtained by the light source module has a wide color temperature coverage range and a color deviation Duv value less than 0.003, thereby solving the problem of white light color deviation. In addition, the white light spectrum of the light source module simulates a target spectrum, when the correlated color temperature is 4000K or above, the target spectrum being the solar spectrum, and when the correlated color temperature is lower than 4000K, the target spectrum being the blackbody radiation spectrum. Because the spectrum simulates the solar or blackbody radiation spectrum, the obtained white light spectrum has a good color rendering index and spectral similarity, such that the color of the white light of the light source module is closer to that of daylight, thereby being more adapted to the field of general lighting.

## Description

### CROSS-REFERENCE TO RELATED APPLICATIONS

This application claims priority to invention patent application No. 202311582047.9 filed with the China National Intellectual Property Administration (CNIPA) on November 23, 2023, entitled "LIGHT SOURCE MODULE, LIGHTING SYSTEM AND LIGHTING FIXTURE", and utility model patent application No. 202323178453.7 filed with the CNIPA on November 23, 2023, entitled "LIGHT SOURCE MODULE, LIGHTING SYSTEM AND LIGHTING FIXTURE". The entire contents of these applications are incorporated herein by reference.

### TECHNICAL FIELD

The present disclosure relates to a light source module, a lighting system and a lighting fixture.

### BACKGROUND

In the lighting industry, light-emitting diodes (LEDs) have rapidly replaced conventional light sources and have been applied to various lighting fixtures such as indoor and outdoor lighting, smart lighting, horticultural lighting, automotive lighting, and indoor and outdoor display lighting due to their low power consumption and high luminous efficiency. With continuous improvements in performance and cost-effectiveness of LED lighting, its market penetration has increased accordingly. Meanwhile, users have raised higher requirements for lighting quality. In terms of color rendering properties, the color rendering index (CRI) has evolved from an initial value of 70 to 80, 90, and even above 95 or 97. In terms of spectral evolution, the goal is to progressively approximate a natural light spectrum by supplementing or mitigating specific visible wavelengths to enhance the matching degree with the natural light spectrum. In addition, dimming of superimposed dual-color-temperature light is implemented to realize lighting scenarios with different color temperature ranges, so as to constitute a dimming and color-tuning lighting product capable of taking high light quality into consideration.

Nevertheless, conventional single-color-temperature or dual-color-temperature white-light dimming methods are limited in adjustable color temperature range, which is determined by the color temperatures of the two white-light chips as used. Moreover, the dimming trajectory follows a straight line connecting the chromaticity coordinate points of the two color temperatures on the CIE 1931 chromaticity diagram. When tuned to an intermediate color temperature, the chromaticity point deviates significantly from the black-body locus, resulting in obvious discrepancies in light color and spectrum compared with standard light sources of the same color temperature. Furthermore, light quality at intermediate color temperatures is compromised, especially in the special color rendering indices R9 and R12, showing a large gap compared with full-spectrum single white light at the same color temperature. Generally, in order to mitigate severe color deviation at intermediate color temperatures, two white-light chips with smaller color temperature differences can be adopted for dimming, or the chromaticity specifications of the two white-light chips can be adjusted to keep the chromaticity point at the target value and reduce color deviation when tuned to intermediate color temperatures. However, for the two methods, the former further narrows the adjustable white-light color temperature range, while the latter ensures light quality at intermediate color temperatures at the expense of light performance at the maximum and minimum color temperatures. Regardless of the white-light spectrum specifications as adopted (even full-spectrum white-light chips), the aforementioned problems of limited adjustable color temperature range and degraded light quality caused by significant color deviation persist.

In addition, to further expand the overall white-light color temperature range, red-green-blue (RGB) primary colors are commonly added to conventional single-color-temperature or dual-color-temperature white-light chips for dimming and color tuning, namely multi-color mixing modes such as RGBW or RGBCW. The mixing principle of such mixing mode is as follows: when the target color temperature falls within the range of single-color-temperature or dual-color-temperature white light, white-light chips serve as the main mixing components; when the target color temperature exceeds this range, RGB primary colors are mixed or color compensation is applied to obtain white light of the required target color temperature. In either case, the color rendering performance of white light obtained via such multi-color mixing is only guaranteed within the color temperature range covered by the original white-light chips. Outside this range, since LEDs for RGB primary colors are mainly composed of single-wavelength LED chips with narrow full-width half-maximum (FWHM) for each monochromatic light, the resulting mixed white-light spectrum suffers poor continuity, failing to maintain a high color rendering index beyond the color temperature range of white-light chips.

With the improvement of living standards, people's lighting demands have become more diversified. Developing a lighting fixture that fully simulates the color temperature variation of outdoor natural daylight and delivers light quality comparable to natural daylight has become an urgent technical challenge to be addressed.

### SUMMARY

The objective of the present disclosure is to solve the above-mentioned problems and provide a multi-color light source module, a lighting system and a lighting fixture with adjustable white-light color temperature capable of generating full-spectrum white light.

To achieve the above functions, the technical solution adopted by the present disclosure provides a light source module, characterized by including a first light-emitting unit, a second light-emitting unit and a third light-emitting unit which are electrically independent of one another. The first light-emitting unit includes a first light-emitting source, a first encapsulant covering the first light-emitting source, and a first phosphor body. Light emitted by the first light-emitting unit has at least three spectral emission peaks; a first peak wavelength is in a range of 430-445 nm; a second peak wavelength is in a range of 460-480 nm, and a spectral intensity at the second peak wavelength is 60-90% of a spectral intensity at the first peak wavelength; a third peak wavelength is in a range of 520-550 nm, and a spectral intensity at the third peak wavelength is 20-50% of a spectral intensity at the first peak wavelength; a light color of the first light-emitting unit is blue-green light falling within a quadrilateral region enclosed by four points of A1 (0.24, 0.26), A2 (0.26, 0.31), A3 (0.29, 0.26) and A4 (0.26, 0.23) on a CIE 1931 chromaticity diagram. The second light-emitting unit includes a second light-emitting source, a second encapsulant covering the second light-emitting source, and a second phosphor body. Light emitted by the second light-emitting unit has at least three spectral emission peaks; a first peak wavelength is in a range of 445-460 nm; a second peak wavelength is in a range of 520-550 nm, and a spectral intensity at the first peak wavelength is 40-70% of a spectral intensity at the second peak wavelength; a third peak wavelength is in a range of 560-590 nm, and a spectral intensity at the third peak wavelength is 70-100% of a spectral intensity at the second peak wavelength; a light color of the second light-emitting unit is green light falling within a quadrilateral region enclosed by four points of B1 (0.33, 0.42), B2 (0.36, 0.47), B3 (0.40, 0.45) and B4 (0.37, 0.42) on the CIE 1931 chromaticity diagram. The third light-emitting unit includes a third light-emitting source, a third encapsulant covering the third light-emitting source, and a third phosphor body. Light emitted by the third light-emitting unit has at least two spectral emission peaks; a first peak wavelength is in a range of 630-680 nm; a second peak wavelength is in a range of 540-580 nm, and a spectral intensity at the second peak wavelength is 10-40% of a spectral intensity at the first peak wavelength; a light color of the third light-emitting unit is orange-red light falling within a quadrilateral region enclosed by four points of C1 (0.53, 0.42), C2 (0.56, 0.43), C3 (0.60, 0.39) and C4 (0.55, 0.39) on the CIE 1931 chromaticity diagram.

Further, a blue-light content of the third light-emitting unit is less than 10%.

Further, the first light-emitting source is an LED chip assembly including two or more types of blue LED chips with different peak wavelengths. The blue LED chip has a peak wavelength of 430-475 nm, and a peak wavelength difference between different types of blue LED chips is greater than or equal to 10 nm.

Further, a first blue LED chip has a peak wavelength of 430-445 nm; a second blue LED chip has a peak wavelength of 445-460 nm; a third blue LED chip has a peak wavelength of 460-475 nm. The peak wavelength difference between any two of the first blue LED chip, the second blue LED chip and the third blue LED chip is greater than or equal to 10 nm. The first light-emitting source includes at least two of the first blue LED chip, the second blue LED chip and the third blue LED chip; and each of the second light-emitting source and the third light-emitting source is the second blue LED chip.

Further, the first phosphor body includes at least one yellow-green phosphor with a peak wavelength of 500-580 nm and at least one red phosphor with a peak wavelength of 610-680 nm. The yellow-green phosphor is selected from a group consisted of (Lu,Yb,Tb)₃(Al,Ga)₅O₁₂:Ce, Ga-Y₃Al₅O₁₂:Ce and Y₃(Al,Ga)₅O₁₂:Ce. The red phosphor is selected from a group consisted of CaAlSiN₃:Eu, (Ca,Sr)AlSiN₃:Eu, (Ba,Sr,Ca,Mg)₂Si₅N₈:Eu, K₂SiF₆:Mn⁴⁺, K₂GeF₆:Mn⁴⁺ and K₂TiF₆:Mn⁴⁺.

Further, the second phosphor body includes at least one blue-green phosphor with a peak wavelength of 485-515 nm, at least two yellow-green phosphors with peak wavelengths of 500-580 nm, and at least one red/orange phosphor with a peak wavelength of 580-620 nm. The blue-green phosphor is (Ba,Sr)Si₂N₂O₂:Eu. The yellow-green phosphor is selected from a group consisted of (Lu,Yb,Tb)₃(Al,Ga)₅O₁₂:Ce, Ga-Y₃Al₅O₁₂:Ce and Y₃(Al,Ga)₅O₁₂:Ce. The red/orange phosphor is selected from a group consisted of CaAlSiN₃:Eu, (Ca,Sr)AlSiN₃:Eu, (Ba,Sr,Ca,Mg)₂Si₅N₈:Eu, K₂SiF₆:Mn⁴⁺, K₂GeF₆:Mn⁴⁺ and K₂TiF₆:Mn⁴⁺.

Further, the third phosphor body includes at least one yellow-green phosphor with a peak wavelength of 520-580 nm and at least one red phosphor with a peak wavelength of 630-680 nm. The yellow-green phosphor is selected from a group consisted of (Lu,Yb,Tb)₃(Al,Ga)₅O₁₂:Ce, Ga-Y₃Al₅O₁₂:Ce and Y₃(Al,Ga)₅O₁₂:Ce. The red phosphor is selected from a group consisted of CaAlSiN₃:Eu, (Ca,Sr)AlSiN₃:Eu, (Ba,Sr,Ca,Mg)₂Si₅N₈:Eu, K₂SiF₆:Mn⁴⁺, K₂GeF₆:Mn⁴⁺ and K₂TiF₆:Mn⁴⁺.

Further, white light formed by mixing light emitted from the first light-emitting unit, the second light-emitting unit and the third light-emitting unit has an adjustable correlated color temperature ranging from 1800 K to 14000 K, and a chromaticity deviation Duv from a black-body locus which is less than 0.003.

Further, the white light formed by mixing the light emitted from the first light-emitting unit, the second light-emitting unit and the third light-emitting unit simulates a target spectrum, with spectral similarity higher than 88% relative to the target spectrum within the correlated color temperature range of 2700-14000 K. The target spectrum is a daylight spectrum when the correlated color temperature is above 4000 K; and the target spectrum is a black-body radiation spectrum when the correlated color temperature is below 4000 K.

Further, a color rendering index (CRI) of the white light formed by mixing the light emitted from the first light-emitting unit, the second light-emitting unit and the third light-emitting unit is greater than 95 within the correlated color temperature range of 1800-14000 K.

Further, the color rendering index (CRI) of the white light formed by mixing the light emitted from the first light-emitting unit, the second light-emitting unit and the third light-emitting unit is greater than 97 within the correlated color temperature range of 2700-14000 K; wherein all special color rendering indices R1-R15 are greater than 90, a color fidelity index Rf under TM-30 standard is greater than 95, and a color gamut index Rg is within 100±2.

Further, the light source module is a packaged chip including a main body portion provided with a first accommodating groove, a second accommodating groove and a third accommodating groove. The first light-emitting source and the first phosphor body are disposed in the first accommodating groove; the second light-emitting source and the second phosphor body are disposed in the second accommodating groove; and the third light-emitting source and the third phosphor body are disposed in the third accommodating groove. The first encapsulant, the second encapsulant and the third encapsulant fill the first accommodating groove, the second accommodating groove and the third accommodating groove, respectively, and cover the first light-emitting source, the second light-emitting source and the third light-emitting source, respectively.

The present disclosure further provides a lighting system, characterized by including a light source and a driving circuit. The light source includes at least one light source module as described above. The driving circuit is electrically connected to and supplies power to the first light-emitting unit, the second light-emitting unit and the third light-emitting unit, respectively, and controls a current/voltage supplied to the first light-emitting unit, the second light-emitting unit and the third light-emitting unit, respectively.

Further, the driving circuit includes: a power conversion module, configured to convert an external power supply into a DC power supply required by the light source module; a control module, configured to generate a control signal; and an LED driving module, configured to receive the DC power supply output by the power conversion module and the control signal transmitted from the control module, and regulate the DC power supply according to the control signal. The LED driving module is electrically connected to the first light-emitting unit, the second light-emitting unit and the third light-emitting unit, respectively, and outputs regulated driving current/voltage required by the first light-emitting unit, the second light-emitting unit and the third light-emitting unit, respectively.

Further, the control signal is PWM signal.

Further, the control module includes a communication module configured to receive an external dimming/color-tuning command and generate the control signal according to the external dimming/color-tuning command.

Further, the control module includes: a storage module storing preset control parameter values, which correspond to the first light-emitting unit, the second light-emitting unit and the third light-emitting unit when the light source module generates white light of different color temperatures. When the light source module is controlled according to the control parameter values, white light formed by mixing light emitted from the first light-emitting unit, the second light-emitting unit and the third light-emitting unit has an adjustable correlated color temperature ranging from 1800 K to 14000 K, a chromaticity deviation Duv from a black-body locus which is less than 0.003, and a color rendering index (CRI) greater than 95.

Further, controlling the light source module according to the control parameter values realizes simulation of a target spectrum, with spectral similarity higher than 88% relative to a target spectrum within the correlated color temperature range of 2700-14000 K. The target spectrum is a daylight spectrum when the correlated color temperature is above 4000 K; and the target spectrum is a black-body radiation spectrum when the correlated color temperature is below 4000 K.

Further, when the light source module is controlled according to the control parameter values, the color rendering index (CRI) of white light emitted by the light source module is greater than 97 within the correlated color temperature range of 2700-14000 K, wherein all special color rendering indices R1-R15 are greater than 90, a color fidelity index Rf under TM-30 standard is greater than 95, and a color gamut index Rg is within a range of 100±2.

Further, the light source includes two or more light source modules. The first light-emitting units, the second light-emitting units and the third light-emitting units of the two or more light source modules are connected in series, respectively, and then electrically connected to the LED driving module.

The present disclosure further provides a lighting fixture, characterized by including the above-described light source module or lighting system.

### BRIEF DESCRIPTION OF DRAWINGS

Fig. 1 is a schematic structural diagram of a light source module according to a preferred embodiment of the present disclosure;
Fig. 2 is a chromaticity point distribution diagram of a first light-emitting unit, a second light-emitting unit and a third light-emitting unit of the light source module according to the preferred embodiment of the present disclosure on the CIE 1931 chromaticity diagram;
Fig. 3 is a spectral energy distribution diagram of the first light-emitting unit, the second light-emitting unit and the third light-emitting unit of the light source module according to the preferred embodiment of the present disclosure;
Fig. 4 is a comparison diagram of emission spectral curves between White-light Embodiment a emitted by the light source module according to the preferred embodiment of the present disclosure and a standard black-body radiation light source (B27);
Fig. 5 is a comparison diagram of emission spectral curves between White-light Embodiment b emitted by the light source module according to the preferred embodiment of the present disclosure and a standard black-body radiation light source (B30);
Fig. 6 is a comparison diagram of emission spectral curves between White-light Embodiment c emitted by the light source module according to the preferred embodiment of the present disclosure and a standard D40 light source;
Fig. 7 is a comparison diagram of emission spectral curves between White-light Embodiment d emitted by the light source module according to the preferred embodiment of the present disclosure and a standard D50 light source;
Fig. 8 is a comparison diagram of emission spectral curves between White-light Embodiment e emitted by the light source module according to the preferred embodiment of the present disclosure and a standard D57 light source;
Fig. 9 is a comparison diagram of emission spectral curves between White-light Embodiment f emitted by the light source module according to the preferred embodiment of the present disclosure and a standard D64 light source;
Fig. 10 is a comparison diagram of emission spectral curves between White-light Embodiment g emitted by the light source module according to the preferred embodiment of the present disclosure and a standard black-body radiation light source;
Fig. 11 is a comparison diagram of emission spectral curves between White-light Embodiment h emitted by the light source module according to the preferred embodiment of the present disclosure and a standard black-body radiation light source;
Fig. 12 is a comparison diagram of emission spectral curves between White-light Embodiment i emitted by the light source module according to the preferred embodiment of the present disclosure and a standard D-series light source;
Fig. 13 is a comparison diagram of emission spectral curves between White-light Embodiment j emitted by the light source module according to the preferred embodiment of the present disclosure and a standard D-series light source;
Figs. 14a, 14b, 14c, 14d, 14e and 14f are schematic diagrams of packaging structures of light source modules according to other preferred embodiments of the present disclosure;
Fig. 15 is a schematic structural diagram of a lighting system according to a preferred embodiment of the present disclosure; and
Fig. 16 is a schematic structural diagram of a lighting fixture according to a preferred embodiment of the present disclosure.

### DETAILED DESCRIPTION

Hereinafter, a light source module, a lighting system and a lighting fixture provided by the present disclosure will be described in further detail with reference to the accompanying drawings and several preferred embodiments in accordance with the present disclosure.

A specific implementation of the light source module of the present disclosure is a mixed-light LED packaged chip, and the packaging form may be PLCC surface-mount packaging, ceramic surface-mount packaging, CSP packaging, multi-in-one monolithic surface-mount packaging or COB chip integrated packaging, which is not limited in the present disclosure.

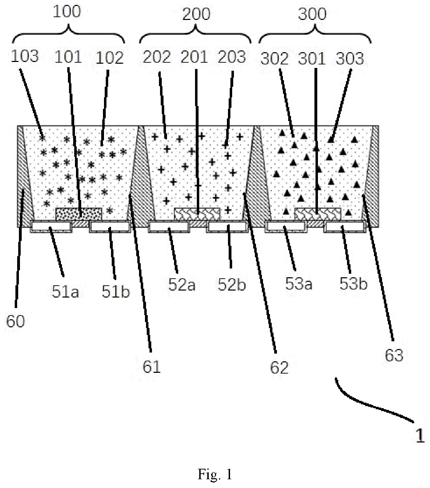

The structure of one specific embodiment is shown in Fig. 1. The light source module 1 includes a main body portion 60, and a plurality of light-emitting units disposed on the main body portion 60 and spaced apart from each other, namely a first light-emitting unit 100, a second light-emitting unit 200 and a third light-emitting unit 300. Each of the light-emitting units 100, 200 and 300 includes a light-emitting source 101, 201, 301 and an encapsulant 102, 202, 302 covering the light-emitting source. The light-emitting sources 101, 201 and 301 are LED chips, which may be in a front-mount or flip-chip configuration, and may be a single LED chip or a plurality of LED chips connected in series, parallel, or series-parallel combination. In this embodiment, to accommodate the encapsulants 102, 202 and 302, the main body portion 60 is a plastic lead frame provided with a plurality of accommodating grooves 61, 62 and 63 therein. The material of the plastic lead frame may be any one of PPA, PCT and EMC. Each light-emitting source 101, 201, 301 is disposed in the corresponding accommodating groove 61, 62, 63 and is provided with a pair of pins 51a-51b, 52a-52b, 53a-53b respectively, and the pins 51a, 51b, 52a, 52b, 53a and 53b are electrically isolated from one another. The encapsulants 102, 202 and 302 are made of silicon-based resin, epoxy resin, or a combination thereof, which are filled into the accommodating grooves 61, 62, 63 respectively and cover the corresponding LED chips 101, 201, 301 to ensure electrical isolation between the respective light-emitting units 100, 200 and 300.

In this embodiment, a multi-source light mixing solution is adopted. The first light-emitting unit 100, the second light-emitting unit 200 and the third light-emitting unit 300 emit blue-green light, green light and orange-red light respectively, and the combination of the three colors can form white light, as specifically described below.

The first light-emitting unit 100 includes a first light-emitting source 101, a first encapsulant 102 and a first phosphor body 103. The first light-emitting source 101 is disposed at the bottom of the first accommodating groove 61 and electrically connected to the outside via two pins 51a and 51b. The first encapsulant 102 fills the first accommodating groove 61 and covers the first light-emitting source 101.

The first light-emitting source 101 is an LED chip assembly including two or more types of blue LED chips with different peak wavelengths, which are connected in series or parallel. The blue LED chips refer to those emitting blue light with a peak wavelength ranging from 430 nm to 475 nm. The reason for adopting a combination of multiple blue LED chips with different peak wavelengths to form the first light-emitting source 101 is that phosphors generally have a broad distribution in terms of full-width half-maximum (FWHM), while monochromatic LED chips feature a narrow FWHM. In this embodiment, although the first phosphor body 103 is incorporated into the first light-emitting unit 100, the blue light component still relies on un-converted energy from LED chip emission. Therefore, given the narrow FWHM of monochromatic LED chips, chips with different peak wavelengths can produce superposed emission in the blue band, resulting in more uniform energy distribution across the blue-light region and superior color rendering performance. In this embodiment, the difference in peak wavelengths between the two types of LED chips is greater than or equal to 10 nm, which ensures a broad energy distribution in the blue-light region. In a preferred solution, blue LED chips with peak wavelengths of 430-475 nm are classified into three types: a first blue LED chip with a peak wavelength of 430-445 nm, a second blue LED chip with a peak wavelength of 445-460 nm, and a third blue LED chip with a peak wavelength of 460-475 nm, where the peak wavelength difference between any two of the three types is guaranteed to be greater than or equal to 10 nm. The first light-emitting source 101 includes a combination of at least two of the first, second and third blue LED chips. Meanwhile, since both the second light-emitting unit 200 and the third light-emitting unit 300 adopt a structure where blue LED chips excite phosphors, the second light-emitting source 201 and the third light-emitting source 301 are also selected from a group consisted of the above-mentioned first, second and third blue LED chips. When the first light-emitting source 101 selects two of the three types, the second light-emitting source 201 and the third light-emitting source 301 select the remaining one type. When the first light-emitting source 101 adopts a combination of the three types, the second light-emitting source 201 and the third light-emitting source 301 each arbitrarily select one of the three types. In this embodiment, the first light-emitting source 101 adopts a combination of the first blue LED chip and the third blue LED chip, and both the second light-emitting source 201 and the third light-emitting source 301 adopt the second blue LED chip.

The first encapsulant 102 contains the first phosphor body 103, which includes at least one yellow-green phosphor with a peak wavelength of 500-580 nm and at least one red phosphor with a peak wavelength of 610-680 nm. To achieve a broad FWHM, the first phosphor body 103 contains both a yellow-green phosphor and a red phosphor with different peak wavelengths. It should be noted that the yellow-green phosphor and red phosphor herein are not limited to a single chemical composition, and each may be a mixed phosphor composed of more than one phosphor to form the required yellow-green or red phosphor. The yellow-green phosphor may be any one or a combination of (Lu,Yb,Tb)₃(Al,Ga)₅O₁₂:Ce, Ga-Y₃Al₅O₁₂:Ce and Y₃(Al,Ga)₅O₁₂:Ce. The red phosphor may be any one or a combination of CaAlSiN₃:Eu, (Ca,Sr)AlSiN₃:Eu, (Ba,Sr,Ca,Mg)₂Si₅N₈:Eu, K₂SiF₆:Mn⁴⁺, K₂GeF₆:Mn⁴⁺ and K₂TiF₆:Mn⁴⁺.

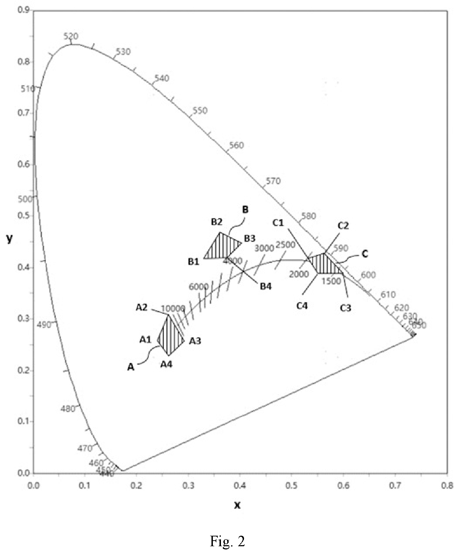

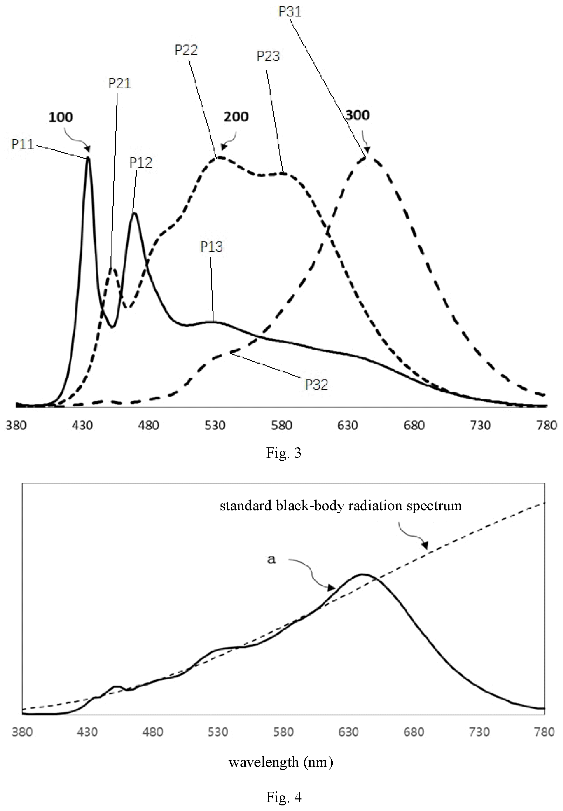

A plurality of blue LED chips of the first light-emitting source 101 are connected in series or parallel and disposed inside the accommodating groove 61. After exciting the first phosphor body 103, the spectral energy distribution of light emitted by the first light-emitting unit 100 is shown as Curve 100 in Fig. 3. Fig. 3 is a relative spectral intensity diagram with all curves normalized, where each point on a curve represents the energy magnitude at a certain wavelength on the horizontal axis. As shown in Fig. 3, the spectral curve of light emitted by the first light-emitting unit 100 includes at least three spectral emission peaks: a first peak wavelength P11 at 430-445 nm, a second peak wavelength P12 at 460-480 nm with a spectral intensity 60-90% of a spectral intensity at the first peak wavelength P11, and a third peak wavelength P13 at 520-550 nm with a spectral intensity 20-50% of a spectral intensity at the first peak wavelength P11. Light emitted by the first light-emitting unit 100 is blue-green in color, which falls within a quadrilateral region enclosed by four points of A1 (0.24, 0.26), A2 (0.26, 0.31), A3 (0.29, 0.26) and A4 (0.26, 0.23) on the CIE 1931 chromaticity diagram, i.e., the region A marked in Fig. 2.

The second light-emitting unit 200 includes a second light-emitting source 201 and a second encapsulant 202. The second light-emitting source 201 is disposed at the bottom of the second accommodating groove 62 and electrically connected to the outside via two pins 52a and 52b. The second encapsulant 202 fills the second accommodating groove 62 and covers the second light-emitting source 201. The second light-emitting source 201 is a blue LED emitting blue light with a peak wavelength of 445-460 nm. The second encapsulant 202 contains a second phosphor body 203, which includes at least one blue-green phosphor with a peak wavelength of 485-515 nm, at least two yellow-green phosphors with peak wavelengths of 500-580 nm, and at least one red/orange phosphor with a peak wavelength of 580-620 nm. The blue-green phosphor may be (Ba,Sr)Si₂N₂O₂:Eu. The yellow-green phosphor may be any combination of two or more selected from a group consisted of (Lu,Yb,Tb)₃(Al,Ga)₅O₁₂:Ce, Ga-Y₃Al₅O₁₂:Ce and Y₃(Al,Ga)₅O₁₂:Ce. The orange/red phosphor may be any one or a combination of CaAlSiN₃:Eu, (Ca,Sr)AlSiN₃:Eu, (Ba,Sr,Ca,Mg)₂Si₅N₈:Eu, K₂SiF₆:Mn⁴⁺, K₂GeF₆:Mn⁴⁺ and K₂TiF₆:Mn⁴⁺. After the second light-emitting source 201 excites the second phosphor body 203, light emitted by the second light-emitting unit 200 includes at least three spectral emission peaks. As shown in Fig. 3, a first peak wavelength P21 is at 445-460 nm, a second peak wavelength P22 is at 520-550 nm with the spectral intensity at the first peak wavelength P21 being 40-70% of the spectral intensity at the second peak wavelength P22, and a third peak wavelength P23 is at 560-590 nm with the spectral intensity at the third peak wavelength P23 being 70-100% of the spectral intensity at the second peak wavelength P22. The spectral energy distribution of the second light-emitting unit 200 is shown as Curve 200 in Fig. 3. Light emitted by the second light-emitting unit 200 is green in color, which falls within a quadrilateral region enclosed by four points of B1 (0.33, 0.42), B2 (0.36, 0.47), B3 (0.40, 0.45) and B4 (0.37, 0.42) on the CIE 1931 chromaticity diagram, i.e., the region B marked in Fig. 2.

The third light-emitting unit 300 includes a third light-emitting source 301 and a third encapsulant 302. The third light-emitting source 301 is disposed at the bottom of the third accommodating groove 63 and electrically connected to the outside via two pins 53a and 53b. The third encapsulant 302 fills the third accommodating groove 63 and covers the third light-emitting source 301. The third light-emitting source 301 is a blue LED emitting blue light with a peak wavelength ranging from 445 nm to 460 nm. The third encapsulant 302 contains a third phosphor body 303, which includes at least one yellow-green phosphor with a peak wavelength of 520-580 nm and at least one red phosphor with a peak wavelength of 630-680 nm. The third phosphor body 303 must contain both yellow-green and red phosphors, each of which may also be a mixed phosphor. The yellow-green phosphor may be any one or a combination of (Lu,Yb,Tb)₃(Al,Ga)₅O₁₂:Ce, Ga-Y₃Al₅O₁₂:Ce and Y₃(Al,Ga)₅O₁₂:Ce. The red phosphor may be any one or a combination of CaAlSiN₃:Eu, (Ca,Sr)AlSiN₃:Eu, (Ba,Sr,Ca,Mg)₂Si₅N₈:Eu, K₂SiF₆:Mn⁴⁺, K₂GeF₆:Mn⁴⁺ and K₂TiF₆:Mn⁴⁺. When the third phosphor body 303 is excited by the third light-emitting source 301, light emitted from the third light-emitting unit 300 includes at least two spectral emission peaks: a first peak wavelength P31 at 630-680 nm, and a second peak wavelength P32 at 540-580 nm with a spectral intensity 10-40% of a spectral intensity at the first peak wavelength P31. The spectral energy distribution of the third light-emitting unit 300 is shown as Curve 300 in Fig. 3. Light emitted by the third light-emitting unit 300 is orange-red in color, which falls within a quadrilateral region enclosed by four points C1 (0.53, 0.42), C2 (0.56, 0.43), C3 (0.60, 0.39) and C4 (0.55, 0.39) on the CIE 1931 chromaticity diagram, i.e., the region C marked in Fig. 2. Since most energy emitted by the third light-emitting source 301 is converted into orange-red light by the third phosphor body 303, the blue light content of light emitted by the third light-emitting unit 300 is less than 10%. Herein, the blue light content being less than 10% means that the energy proportion of the blue-light band of 440-480 nm in the total luminous energy emitted by the light-emitting unit is less than 10%.

It is well known that white light can be formed by mixing three primary colors. Conventional solutions produce white light via RGB three-color mixing. In this embodiment, the existing RGB solution is optimized by selecting different light colors such that the first light-emitting unit 100 emits blue-green light, the second light-emitting unit 200 emits green-yellow light, and the third light-emitting unit 300 emits orange-red light. Full-spectrum white light can be obtained by combining light from the three units. The full-spectrum white light provided by embodiments of the present disclosure is realized by simulating a target spectrum. When the target color temperature is lower than 4000 K, the emission spectrum of the light source module 1 takes the black-body radiation spectrum as the target spectrum. When the target color temperature is higher than 4000 K, the emission spectrum of the light source module 1 takes a simulated daylight spectrum as the target spectrum. The daylight spectrum herein refers to the relative spectral power distribution of D-series standard illuminants specified by the International Commission on Illumination (CIE), such as standard light sources D50, D57, D65, etc. In addition, the black-body radiation spectrum at different color temperatures (T) satisfies the following relationship with relative to the black-body radiation spectrum (B): ${B}_{λ} \left(T\right) = \frac{2 {hc}^{2}}{{λ}^{5}} \frac{1}{{e}^{\frac{hc}{{KT}_{{B}^{λ} - 1}}}} ,$ where T denotes the color temperature, h denotes the Planck constant, c denotes the speed of light (3×10⁸ m/s), K denotes the Boltzmann constant, T_{B} denotes the absolute temperature of black body, and λ denotes the radiation wavelength.

To evaluate the simulated matching degree between the white-light spectrum obtained in the embodiments and the target spectrum, and given that no relevant evaluation standard has been issued by authoritative institutions at present, the spectral matching degree adopted in the present disclosure, namely Spectral Similarity (SS), is evaluated by referring to the Average Spectral Difference (ASD) released by Bridgelux Inc., USA, in which the spectra of reference light sources at different color temperatures as adopted are similar to those under the TM-30 standard published by the Illuminating Engineering Society of North America (IES). Specifically, when the color temperature is above 5000 K, the reference spectrum is based on D-series standard illuminants; when the color temperature is below 4000 K, the reference spectrum is based on the spectrum emitted by a black-body radiation light source; when the color temperature ranges from 4000 K to 5000 K, the reference spectrum is derived from a mixed light source of a 4000 K black-body radiation light source and the D50 standard illuminant. In addition, considering the spectral distribution of human eye visual sensitivity, the spectral deviation evaluation range is limited to 425 nm to 690 nm. The specific calculation method is shown as follows: $ASD = \frac{{\sum }_{λ = 425}^{λ = 690} \left|\frac{{ϕ}_{ref} - ϕ}{{ϕ}_{ref}}\right|}{266} ∗ 100 % ,$ $SS = 1 - ASD ,$ where φ_{ref} is the relative intensity of the reference light source, φ is the relative intensity of the light source to be evaluated, and λ is the wavelength.

White light with various color temperatures can be mixed by dimming and controlling the three light-emitting units respectively. In this embodiment, PWM signals are adopted as control signals. The three-color light-emitting units are independently controlled via PWM dimming, and different duty cycles are applied to adjust the luminous power of each light-emitting unit, thereby achieving the light-mixing effect. Table 1 lists several specific embodiments obtained by adjusting the duty cycles of PWM signals for the three light-emitting units under different conditions, covering a general white-light color temperature range from 2700 K to 6500 K. Table 1 shows the PWM duty cycle of each light-emitting unit, as well as the actual color temperature, the chromaticity deviation from the black-body locus (Duv), the spectral similarity, the color rendering index (CRI), the color fidelity index (Rf), the color gamut index (Rg), and the special color rendering indices R1 to R15 of the full-spectrum white light realized by the light source module 1 through adjusting the PWM signals of the three light-emitting units.

**Table 1**

| | a | b | c | d | e | f |
|---|---|---|---|---|---|---|
| PWM duty cycle of first light-emitting unit 100 | 4% | 7% | 21% | 36% | 46% | 56% |
| PWM duty cycle of second light-emitting unit 200 | 19% | 22% | 28% | 28% | 26% | 22% |
| PWM duty cycle of third light-emitting unit 300 | 77% | 71% | 51% | 36% | 28% | 22% |
| Correlated Color Temperature (CCT, K) | 2705 | 2987 | 4015 | 4984 | 5762 | 6474 |
| Chromaticity Deviation (Duv) | 0.001 | 0.000 | -0.001 | 0.000 | 0.001 | 0.001 |
| Spectral Similarity (SS) | 90% | 91% | 90% | 90% | 90% | 90% |
| CRI (Ra) | 97.1 | 97.2 | 98.5 | 98.5 | 98.3 | 98.2 |
| Color Fidelity Index (Rf) | 96 | 97 | 97 | 97 | 97 | 97 |
| Color Gamut Index (Rg) | 100 | 100 | 101 | 101 | 100 | 100 |
| R1 | 96 | 96 | 98 | 99 | 99 | 99 |
| R2 | 98 | 98 | 99 | 100 | 99 | 99 |
| R3 | 97 | 98 | 98 | 99 | 98 | 98 |
| R4 | 95 | 96 | 98 | 98 | 99 | 99 |
| R5 | 96 | 96 | 98 | 99 | 99 | 99 |
| R6 | 96 | 96 | 98 | 98 | 98 | 97 |
| R7 | 99 | 100 | 99 | 98 | 98 | 98 |
| R8 | 98 | 98 | 100 | 97 | 96 | 97 |
| R9 | 98 | 96 | 99 | 93 | 91 | 91 |
| R10 | 98 | 97 | 99 | 99 | 98 | 98 |
| R11 | 92 | 93 | 97 | 99 | 99 | 99 |
| R12 | 95 | 95 | 95 | 92 | 97 | 96 |
| R13 | 96 | 96 | 98 | 99 | 99 | 99 |
| R14 | 97 | 98 | 98 | 99 | 99 | 99 |
| R15 | 98 | 97 | 98 | 98 | 99 | 100 |

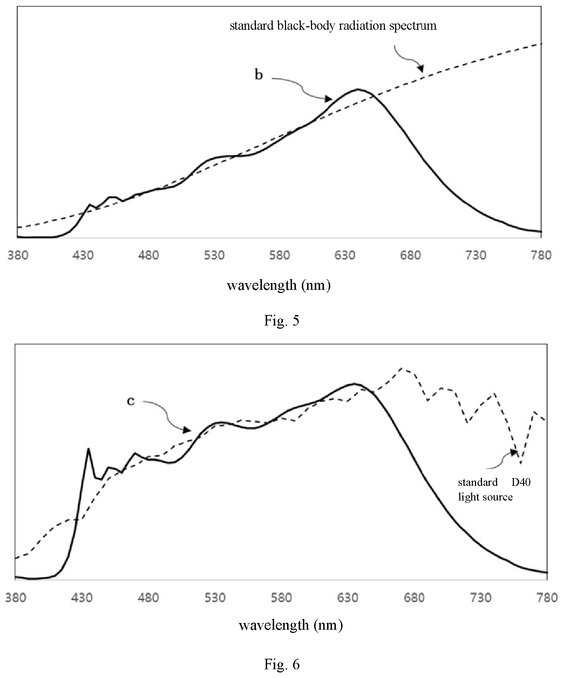

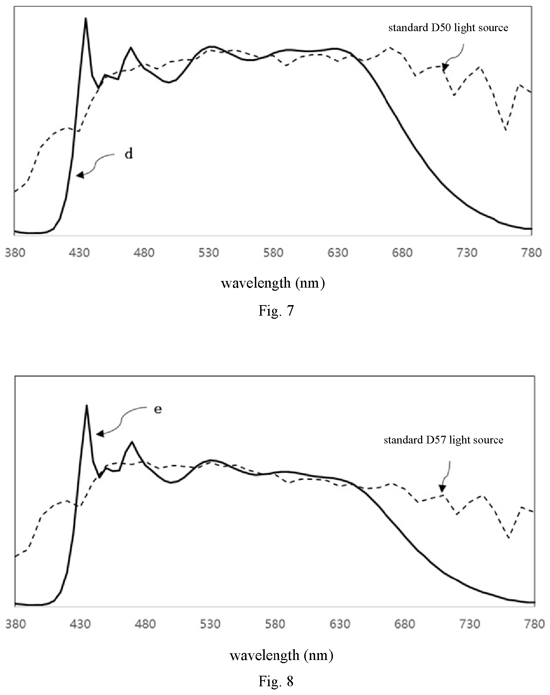

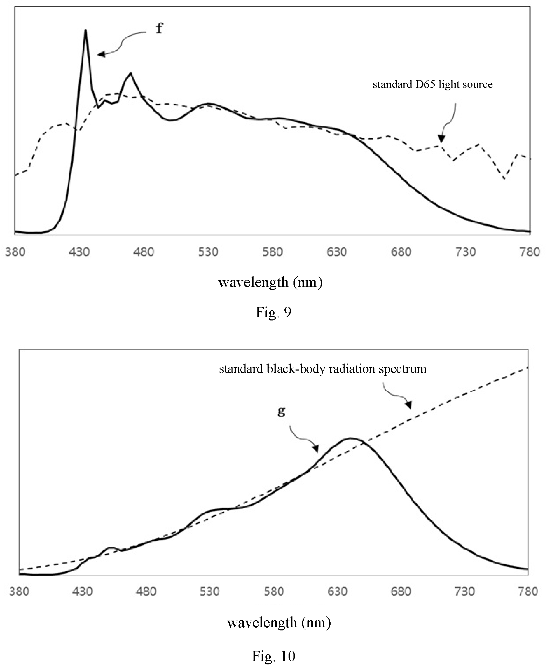

Embodiments a, b, c, d, e and f in the table correspond to target color temperatures of 2700 K, 3000 K, 4000 K, 5000 K, 5700 K and 6500 K respectively. The target color temperature refers to the desired color temperature. Due to individual differences among products, the actual value may deviate slightly from the defined target color temperature, and the color temperatures listed in the table are measured values of various embodiments. The spectral energy distribution of full-spectrum white light obtained in each embodiment and its comparison with the target spectrum are shown in Figs. 4 to 9. Specifically, Fig. 4 is a comparison diagram of emission spectral curves between Embodiment a and a standard black-body radiation light source (B27); Fig. 5 is a comparison diagram of emission spectral curves between Embodiment b and a standard black-body radiation light source (B30); Fig. 6 is a comparison diagram of emission spectral curves between Embodiment c and a standard D40 light source; Fig. 7 is a comparison diagram of emission spectral curves between Embodiment d and a standard D50 light source; Fig. 8 is a comparison diagram of emission spectral curves between Embodiment e and a standard D57 light source; and Fig. 9 is a comparison diagram of emission spectral curves between Embodiment f and a standard D65 light source.

In addition to the data of embodiments listed in Table 1, the white-light correlated color temperature achievable by the light source module 1 provided in the present disclosure covers a wider range than that of conventional white-light sources. Table 2 lists embodiment data of the light source module 1 in two white-light color temperature ranges of 1800 K-2700 K and 6500 K-14000 K, including the control duty cycle of each channel and relevant light quality parameters.

**Table 2**

| | g | h | i | j |
|---|---|---|---|---|
| PWM duty cycle of first light-emitting unit 100 | 1% | 1% | 83% | 97% |
| PWM duty cycle of second light-emitting unit 200 | 0% | 14% | 10% | 2% |
| PWM duty cycle of third light-emitting unit 300 | 99% | 85% | 7% | 1% |
| Correlated Color Temperature (CCT, K) | 1803 | 2430 | 10310 | 14302 |
| Chromaticity Deviation (Duv) | 0.001 | 0.000 | -0.0007 | -0.0010 |
| Spectral Similarity (SS) | 82% | 89% | 89% | 89% |
| CRI (Ra) | 97.0 | 96.5 | 97.8 | 97.3 |
| Color Fidelity Index (Rf) | 94 | 96 | 95 | 95 |
| Color Gamut Index (Rg) | 99 | 101 | 100 | 100 |
| R1 | 99 | 96 | 97 | 96 |
| R2 | 100 | 98 | 98 | 98 |
| R3 | 94 | 97 | 97 | 97 |
| R4 | 96 | 94 | 98 | 97 |
| R5 | 99 | 95 | 97 | 97 |
| R6 | 97 | 95 | 96 | 95 |
| R7 | 97 | 100 | 99 | 99 |
| R8 | 94 | 98 | 99 | 99 |
| R9 | 87 | 98 | 97 | 93 |
| R10 | 96 | 97 | 97 | 97 |
| R11 | 90 | 89 | 98 | 98 |
| R12 | 96 | 93 | 94 | 93 |
| R13 | 99 | 96 | 98 | 97 |
| R14 | 94 | 97 | 98 | 98 |
| R15 | 96 | 98 | 97 | 96 |

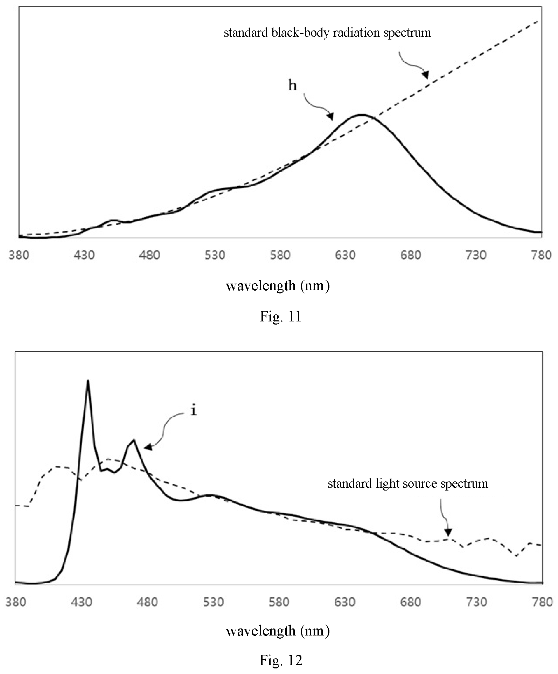

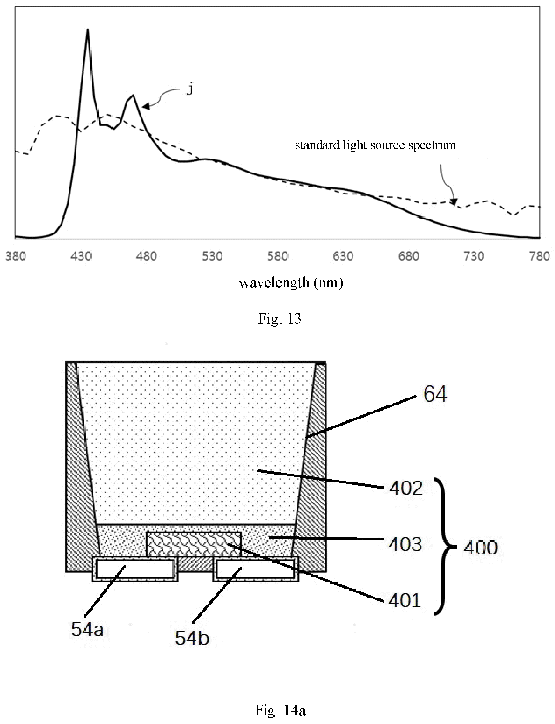

The spectral energy distribution of full-spectrum white light obtained from each embodiment listed in the tables and its comparison with the target spectrum are shown in Figs. 10 to 13. Specifically, Fig. 10 is a comparison diagram of emission spectral curves between Embodiment g and a standard black-body radiation light source; Fig. 11 is a comparison diagram of emission spectral curves between Embodiment h and a standard black-body radiation light source; Fig. 12 is a comparison diagram of emission spectral curves between Embodiment i and a standard D-series light source; and Fig. 13 is a comparison diagram of emission spectral curves between Embodiment j and a standard D-series light source.

As can be seen from Table 1 and Table 2, the full-spectrum white light generated by mixing light from the first light-emitting unit 100, the second light-emitting unit 200 and the third light-emitting unit 300 in the present embodiment features a wide color temperature coverage ranging from 1800 K to 14000 K. The chromaticity deviation Duv from the black-body locus is less than 0.003, ensuring purer light color of the entire light source module at any color temperature. Meanwhile, the obtained white-light spectrum has a high spectral similarity to the target spectrum. When the color temperature of white light emitted by the light source module ranges from 2400 K to 14000 K, the spectral similarity is higher than 88%, i.e., the white-light spectrum reaches the full-spectrum level within substantially the entire adjustable color temperature range of the light source module. Several conventional LED light sources with a correlated color temperature of 4000 K are listed herein, and their SS values are calculated by using the above-mentioned evaluation method to serve as comparative reference values for the embodiments of the present disclosure. Specifically, the spectral similarity of conventional Ra80 white-light LEDs is 68%, the spectral similarity of conventional Ra90 white-light LEDs is 78%, and the spectral similarity of conventional Ra95 white-light LEDs is 81%. The spectral similarity of these existing products is significantly lower than that of the light source module 1 provided in the present disclosure. In terms of color rendering performance, benefiting from its high spectral similarity, the color rendering index (CRI) of white light emitted by the light source module is higher than 95 across the color temperature range of 1800 K-14000 K, and higher than 97 within a range of 2700 K-14000 K, in which R1-R15 are all greater than 90. In addition, the color fidelity index Rf under the TM-30 standard exceeds 95, and the color gamut index Rg falls within the range of 100±2. In summary, the light source module 1 achieves advantages including wider color temperature range, higher spectral similarity and excellent color rendering performance at the same time.

The embodiment shown in Fig. 1 illustrates one packaging structure of the light source module 1, in which four light-emitting units are packaged integrally. In other preferred embodiments, each light-emitting unit may also be packaged independently and finally arranged on the same substrate to form the light source module 1. Alternatively, the first light-emitting unit 100 and the second light-emitting unit 200 may be packaged together while the third light-emitting unit 300 is packaged independently, which is not limited in the present disclosure.

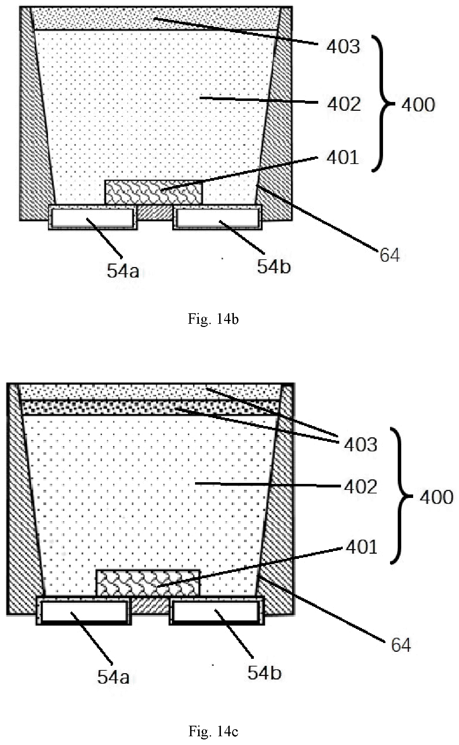

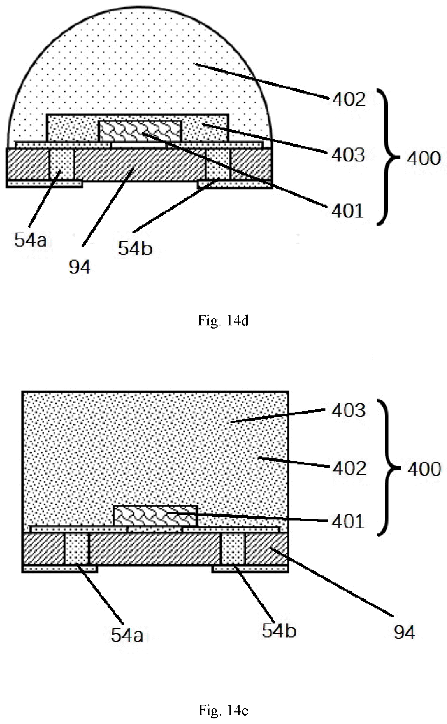

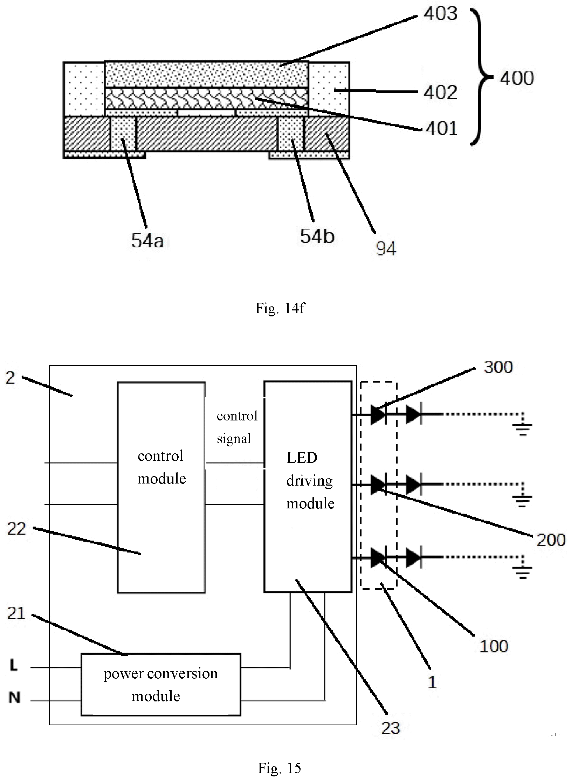

There are numerous available packaging structures for independent packaging. Since the first light-emitting unit 100, the second light-emitting unit 200 and the third light-emitting unit 300 share the same structure, a fourth light-emitting unit 400 with a similar structure is taken as an example to describe other preferred independent packaging forms. The fourth light-emitting unit 400 likewise includes a fourth light-emitting source 401, a fourth encapsulant 402 covering the fourth light-emitting source 401, and a fourth phosphor body 403. The packaging structures of the embodiments in Figs. 14a and 14b adopt a lead-frame structure as in the embodiment of Fig. 1, with a fourth accommodating groove 64 formed on the lead frame. Fig. 14a shows a single light-emitting unit in the light source module 1. After the fourth light-emitting source 401 is mounted, it is electrically connected to the outside via pins 54a and 54b. The fourth phosphor body 403 is first spread flatly on the surface of the fourth light-emitting source 401 by spraying or coating, and then the fourth encapsulant 402 fills the fourth accommodating groove 64. In Fig. 14b, the fourth encapsulant 402 first fills the fourth accommodating groove 64 with the fourth light-emitting source 401 placed therein, and subsequently the fourth phosphor body 403 is spread flatly on the upper surface of the fourth encapsulant 402 by spraying or coating. As mentioned above, the fourth phosphor body 403 of the fourth light-emitting unit 400 contains multiple types of phosphors. The packaging structure of Fig. 14c differs from that of Fig. 14b in that different types of phosphors are coated in layers, thereby forming a double-layer structure as illustrated. Fig. 14d shows a high-power ceramic packaging structure, where a ceramic or metal material is adopted for the substrate 94. The fourth light-emitting source 401 is disposed on the substrate 94. The fourth phosphor body 403 forms a light conversion layer on the surface of the fourth light-emitting source 401 by spraying, phosphor film laminating or phosphor ceramic sheet mounting method, after which the fourth encapsulant 402 fills the groove by mold injection molding to cover the fourth phosphor body 403 and the fourth light-emitting source 401. Fig. 14e shows CSP packaging suitable for high-power chips, in which a ceramic or metal material is adopted for the substrate 94, the fourth phosphor body 403 is mixed with the fourth encapsulant 402, and a light conversion layer is formed on the surface of the fourth light-emitting source 401 by phosphor film laminating to complete packaging. The structure of Fig. 14f is similar to that of Fig. 14e, in which a ceramic or metal substrate 94 is also adopted, the fourth phosphor body 403 forms a light conversion layer on the surface of the fourth light-emitting source 401 by spraying or phosphor film laminating, and the fourth encapsulant 402 is disposed on the outer side of the light conversion layer to complete packaging. All the above methods can achieve the objectives of the present disclosure, which is not limited herein.

Another preferred embodiment of the present disclosure provides a lighting system as shown in Fig. 15, which includes the above-described light source module 1 and a driving circuit 2.

The driving circuit 2 includes a power conversion module 21, a control module 22 and an LED driving module 23. The power conversion module 21 is connected to an external power supply and converts the external power supply into a DC power supply required by the light source module 1. The control module 22 includes a communication module for receiving external dimming/color-tuning commands and generating control signals based on the external dimming/color-tuning commands. The communication module may be a wired or wireless communication module, which is not limited in the present disclosure. The LED driving module 23 receives the DC power output by the power conversion module 21 and the control signals transmitted from the control module 22, regulates the DC power according to the control signals, and outputs regulated driving current/voltage required respectively by the first light-emitting unit 100, the second light-emitting unit 200 and the third light-emitting unit 300 in the light source module 1. Therefore, the LED driving module 23 needs to be electrically connected to the first light-emitting unit 100, the second light-emitting unit 200 and the third light-emitting unit 300 respectively. When the lighting system includes a plurality of light source modules 1, as shown in Fig. 15, the first light-emitting units 100, the second light-emitting units 200 and the third light-emitting units 300 of respective light source modules 1 are connected in series respectively and then electrically connected to the LED driving module 23.

As described above, the light source module 1 of the embodiment features an adjustable color temperature range of 1800 K-14000 K and needs to simulate a target spectrum. Accordingly, the control module 22 includes a storage module storing preset control parameter values, which correspond to the first light-emitting unit 100, the second light-emitting unit 200 and the third light-emitting unit 300 when the light source module 1 generates white light of different color temperatures. The control parameter values may be voltage values, current values or PWM signals. When a light-emitting unit does not participate in light mixing, its control parameter value is zero. When an external color-temperature change demand is received, the control module 22 receives the command, reads relevant values from the storage module, generates control signals and transmits the control signals to the LED driving module 23, and regulates the output current/voltage to the first light-emitting unit 100, the second light-emitting unit 200 and the third light-emitting unit 300, so that the light source module 1 emits light of a target color or white light with a corresponding color temperature. In this embodiment, the preset control parameters are the duty cycles of PWM signal for various light-emitting units as listed in Table 1 and Table 2. By adopting light-emitting units with specific colors and performing control according to preset parameters, the full-spectrum white light obtained by the light source module 1 has a wider color temperature coverage than that of white light obtained by light mixing in the prior art, i.e., covering a range of 1800 K-14000 K, and has a chromaticity deviation Duv from the black-body locus which is less than 0.003, ensuring purer light color of the entire light source module at any color temperature. Meanwhile, the obtained white-light spectrum has high spectral similarity to the target spectrum. When the color temperature of white light emitted by the light source module 1 ranges from 2400 K to 14000 K, the spectral similarity is higher than 88%, which means that the white-light spectrum reaches the full-spectrum level substantially within the entire adjustable color temperature range of the light source module. In terms of color rendering performance, benefiting from its high spectral similarity, the color rendering index (CRI) of white light emitted by the light source module 1 is higher than 95 across the color temperature range of 1800 K-14000 K, and higher than 97 within a range of 2700 K-14000 K, in which R1-R15 are all greater than 90. In addition, the color fidelity index Rf under the TM-30 standard exceeds 95, and the color gamut index Rg falls within the range of 100±2. In summary, the light source module 1 achieves advantages including wider color temperature range, higher spectral similarity and excellent color rendering performance at the same time.

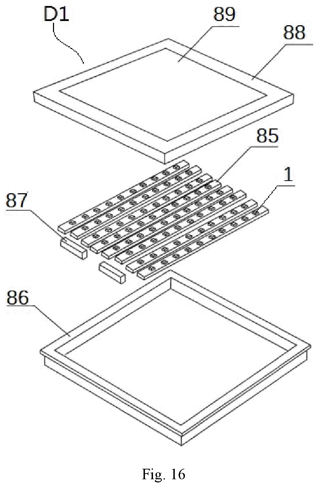

The above-mentioned light source module and lighting system can be applied to various lighting fixtures. Fig. 16 illustrates a lighting fixture D1 according to a preferred embodiment of the present disclosure, which is a panel light including the above-described lighting system. In other preferred embodiments, it may also be a pendant light, a ceiling light, or the like; alternatively, the light source module 1 may be used as an ordinary white-light chip in various lighting fixtures such as table lamps, downlights and spotlights. The lighting fixture D1 includes a luminaire chassis 86, a front frame 88 provided with a diffuser plate 89, a plurality of light source modules 1 mounted on a light source board 85, and a power supply box 87. The aforementioned driving circuit 2 is disposed inside the power supply box 87. In the lighting fixture, separate wiring is implemented for the first light-emitting unit 100, the second light-emitting unit 200 and the third light-emitting unit 300 in each light source module 1. Homologous light-emitting units of all light source modules 1 are connected in series and then connected to the driving circuit 2 in the power supply box 87 to form the aforesaid lighting system. The lighting fixture D1 may further be equipped with a controller, a heat-dissipation device, light distribution components and the like according to specific functions and requirements. The controller can adjust the light color, the light intensity, etc., of irradiation light emitted by the light source module 1. In addition to the diffuser plate in the embodiment, the light distribution components may also include lamp shades, lenses, diffusing elements, light guides and the like, which are not limited in the present disclosure.

The foregoing description of the preferred embodiments of the present disclosure is provided for the purpose of illustration and description, and is not intended to be exhaustive or to limit the present disclosure to the precise forms as disclosed. Obviously, numerous modifications and variations will be apparent to those skilled in the art, which are intended to be included within the scope of the present disclosure defined by the appended claims.

## Claims

1. A light source module, comprising a first light-emitting unit, a second light-emitting unit and a third light-emitting unit which are electrically independent of one another; wherein
the first light-emitting unit comprises a first light-emitting source, a first encapsulant covering the first light-emitting source, and a first phosphor body; light emitted by the first light-emitting unit comprises at least three spectral emission peaks; a first peak wavelength is in a range of 430-445 nm; a second peak wavelength is in a range of 460-480 nm, and a spectral intensity at the second peak wavelength is 60-90% of a spectral intensity at the first peak wavelength; a third peak wavelength is in a range of 520-550 nm, and a spectral intensity at the third peak wavelength is 20-50% of a spectral intensity at the first peak wavelength; a light color of the first light-emitting unit is blue-green light falling within a quadrilateral region enclosed by four points of A1 (0.24, 0.26), A2 (0.26, 0.31), A3 (0.29, 0.26) and A4 (0.26, 0.23) on a CIE 1931 chromaticity diagram;
the second light-emitting unit comprises a second light-emitting source, a second encapsulant covering the second light-emitting source, and a second phosphor body; light emitted by the second light-emitting unit comprises at least three spectral emission peaks; a first peak wavelength is in a range of 445-460 nm; a second peak wavelength is in a range of 520-550 nm, and a spectral intensity at the first peak wavelength is 40-70% of a spectral intensity at the second peak wavelength; a third peak wavelength is in a range of 560-590 nm, and a spectral intensity at the third peak wavelength is 70-100% of a spectral intensity at the second peak wavelength; a light color of the second light-emitting unit is green light falling within a quadrilateral region enclosed by four points of B1 (0.33, 0.42), B2 (0.36, 0.47), B3 (0.40, 0.45) and B4 (0.37, 0.42) on the CIE 1931 chromaticity diagram;
the third light-emitting unit comprises a third light-emitting source, a third encapsulant covering the third light-emitting source, and a third phosphor body; light emitted by the third light-emitting unit comprises at least two spectral emission peaks; a first peak wavelength is in a range of 630-680 nm; a second peak wavelength is in a range of 540-580 nm, and a spectral intensity at the second peak wavelength is 10-40% of a spectral intensity at the first peak wavelength; a light color of the third light-emitting unit is orange-red light falling within a quadrilateral region enclosed by four points of C1 (0.53, 0.42), C2 (0.56, 0.43), C3 (0.60, 0.39) and C4 (0.55, 0.39) on the CIE 1931 chromaticity diagram.

2. The light source module according to claim 1, wherein a blue light content of the third light-emitting unit is less than 10%.

3. The light source module according to claim 1, wherein the first light-emitting source is an LED chip assembly comprising two or more types of blue LED chips with different peak wavelengths; a peak wavelength of the blue LED chip ranges from 430 nm to 475 nm, and a peak wavelength difference between different types of blue LED chips is greater than or equal to 10 nm.

4. The light source module according to claim 3, wherein a first blue LED chip has a peak wavelength of 430-445 nm; a second blue LED chip has a peak wavelength of 445-460 nm; a third blue LED chip has a peak wavelength of 460-475 nm;
the peak wavelength difference between any two of the first blue LED chip, the second blue LED chip and the third blue LED chip is greater than or equal to 10 nm;
the first light-emitting source comprises at least two of the first blue LED chip, the second blue LED chip and the third blue LED chip; and
each of the second light-emitting source and the third light-emitting source is the second blue LED chip.

5. The light source module according to claim 1, wherein the first phosphor body comprises at least one yellow-green phosphor with a peak wavelength of 500-580 nm and at least one red phosphor with a peak wavelength of 610-680 nm; the yellow-green phosphor is selected from a group consisted of (Lu,Yb,Tb)₃(Al,Ga)₅O₁₂:Ce, Ga-Y₃Al₅O₁₂:Ce, and Y₃(Al,Ga)₅O₁₂:Ce; the red phosphor is selected from a group consisted of CaAlSiN₃:Eu, (Ca,Sr)AlSiN₃:Eu, (Ba,Sr,Ca,Mg)₂Si₅N₈:Eu, K₂SiF₆:Mn⁴⁺, K₂GeF₆:Mn⁴⁺, and K₂TiF₆:Mn⁴⁺.

6. The light source module according to claim 1, wherein the second phosphor body comprises at least one blue-green phosphor with a peak wavelength of 485-515 nm, at least two yellow-green phosphors with peak wavelengths of 500-580 nm, and at least one red/orange phosphor with a peak wavelength of 580-620 nm; the blue-green phosphor is (Ba,Sr)Si₂N₂O₂:Eu; the yellow-green phosphor is selected from a group consisted of (Lu,Yb,Tb)₃(Al,Ga)₅O₁₂:Ce, Ga-Y₃Al₅O₁₂:Ce, and Y₃(Al,Ga)₅O₁₂:Ce; and the red/orange phosphor is selected from a group consisted of CaAlSiN₃:Eu, (Ca,Sr)AlSiN₃:Eu, (Ba,Sr,Ca,Mg)₂Si₅N₈:Eu, K₂SiF₆:Mn⁴⁺, K₂GeF₆:Mn⁴⁺, and K₂TiF₆:Mn⁴⁺.

7. The light source module according to claim 1, wherein the third phosphor body comprises at least one yellow-green phosphor with a peak wavelength of 520-580 nm and at least one red phosphor with a peak wavelength of 630-680 nm; the yellow-green phosphor is selected from a group consisted of (Lu,Yb,Tb)₃(Al,Ga)₅O₁₂:Ce, Ga-Y₃Al₅O₁₂:Ce, and Y₃(Al,Ga)₅O₁₂:Ce; and the red phosphor is selected from a group consisted of CaAlSiN₃:Eu, (Ca,Sr)AlSiN₃:Eu, (Ba,Sr,Ca,Mg)₂Si₅N₈:Eu, K₂SiF₆:Mn⁴⁺, K₂GeF₆:Mn⁴⁺, and K₂TiF₆:Mn⁴⁺.

8. The light source module according to claim 1, wherein white light formed by mixing light emitted from the first light-emitting unit, the second light-emitting unit and the third light-emitting unit has an adjustable correlated color temperature ranging from 1800 K to 14000 K, and has a chromaticity deviation Duv from black-body locus which is less than 0.003;
wherein the white light formed by mixing the light emitted from the first light-emitting unit, the second light-emitting unit and the third light-emitting unit simulates a target spectrum, and has a spectral similarity higher than 88% relative to the target spectrum within the correlated color temperature range of 2700 K-14000 K; the target spectrum is a daylight spectrum when the correlated color temperature is above 4000 K, and the target spectrum is a black-body radiation spectrum when the correlated color temperature is below 4000 K;
wherein a color rendering index (CRI) of the white light formed by mixing the light emitted from the first light-emitting unit, the second light-emitting unit and the third light-emitting unit is greater than 95 within the correlated color temperature range of 1800 K-14000 K; and
wherein the color rendering index (CRI) of the white light formed by mixing the light emitted from the first light-emitting unit, the second light-emitting unit and the third light-emitting unit is greater than 97 within the correlated color temperature range of 2700 K-14000 K, and wherein all special color rendering indices R1-R15 are greater than 90, a color fidelity index Rf under TM-30 standard is greater than 95, and a color gamut index Rg is within a range of 100±2.

9. The light source module according to claim 1, wherein the light source module is a packaged chip comprising a main body portion, the main body portion is provided with a first accommodating groove, a second accommodating groove and a third accommodating groove; the first light-emitting source and the first phosphor body are disposed in the first accommodating groove, the second light-emitting source and the second phosphor body are disposed in the second accommodating groove, and the third light-emitting source and the third phosphor body are disposed in the third accommodating groove; the first encapsulant, the second encapsulant and the third encapsulant fill the first accommodating groove, the second accommodating groove and the third accommodating groove, respectively, and cover the first light-emitting source, the second light-emitting source and the third light-emitting source, respectively.

10. A lighting system, comprising: a light source and a driving circuit;
the light source comprises at least one light source module according to any one of claims 1-9; and
the driving circuit is electrically connected to and supplies power to the first light-emitting unit, the second light-emitting unit and the third light-emitting unit, respectively, and controls a current/voltage supplied to the first light-emitting unit, the second light-emitting unit and the third light-emitting unit, respectively.

11. The lighting system according to claim 10, wherein the driving circuit comprises:
a power conversion module, configured to convert an external power supply into a DC power supply required by the light source module;
a control module, configured to generate a control signal; and
an LED driving module, configured to receive the DC power supply output by the power conversion module and the control signal transmitted from the control module, and regulate the DC power supply according to the control signal; wherein the LED driving module is electrically connected to the first light-emitting unit, the second light-emitting unit and the third light-emitting unit, respectively, and outputs regulated driving current/voltage required by the first light-emitting unit, the second light-emitting unit and the third light-emitting unit, respectively;
wherein the control signal is PWM signal.

12. The lighting system according to claim 11, wherein the control module comprises a communication module configured to receive external dimming/color-tuning command and generate the control signal according to the external dimming/color-tuning command.

13. The lighting system according to claim 11, wherein the control module comprises a storage module storing preset control parameter values; the control parameter values correspond to the first light-emitting unit, the second light-emitting unit and the third light-emitting unit when the light source module generates white light of different color temperatures; the light source module is controlled according to the control parameter values, so that white light formed by mixing light emitted from the first light-emitting unit, the second light-emitting unit and the third light-emitting unit has an adjustable correlated color temperature ranging from 1800 K to 14000 K, a chromaticity deviation Duv from the black-body locus which is less than 0.003, and a color rendering index (CRI) greater than 95;
wherein controlling the light source module according to the control parameter values realizes simulation of a target spectrum, with a spectral similarity higher than 88% relative to a target spectrum within the correlated color temperature range of 2700 K-14000 K; the target spectrum is a daylight spectrum when the correlated color temperature is above 4000 K, and a black-body radiation spectrum when the correlated color temperature is below 4000 K;
wherein when the light source module is controlled according to the control parameter values, the Color Rendering Index (CRI) of white light emitted by the light source module is greater than 97 within the correlated color temperature range of 2700 K-14000 K, all special color rendering indices R1-R15 are greater than 90, a color fidelity index Rf under TM-30 standard is greater than 95, and a color gamut index Rg is within a range of 100±2.

14. The lighting system according to claim 11, wherein the light source comprises two or more light source modules; the first light-emitting units, the second light-emitting units and the third light-emitting units of the two or more light source modules are connected in series, respectively, and then electrically connected to the LED driving module.

15. A lighting fixture, comprising the light source module according to any one of claims 1-9, or the lighting system according to any one of claims 10-14.
